Europäisches Patentamt

**European Patent Office**

Office européen des brevets

(19)

(11) Veröffentlichungsnummer: **0 060 436**
A1

# EUROPÄISCHE PATENTANMELDUNG

(12)

(21) Anmeldenummer: 82101568.2

(22) Anmeldetag: 01.03.82

(51) Int. Cl.³: **H 01 L 27/01**

(30) Priorität: 02.03.81 DE 3107943

(43) Veröffentlichungstag der Anmeldung: 22.09.82
**Patentblatt 82/38**

(84) Benannte Vertragsstaaten: **BE FR GB IT NL SE**

(71) Anmelder: **SIEMENS AKTIENGESELLSCHAFT Berlin
und München, Postfach 22 02 61,
D-8000 München 22 (DE)**

(72) Erfinder: **Grewal, Virinder, Dr., Karwendelstrasse 45,
D-8017 Ebersberg (DE)**
Erfinder: **Reindl, Werner, Kirchfeldstrasse 6,
D-8025 Unterhaching (DE)**

(54) Verfahren zur Herstellung von lötbaren und temperfähigen edelmetallfreien Dünnschichtleiterbahnen.

(57)    Das Gebiet der Dünnfilmtechnik umfaßt integrierte Hybridschaltungen, Widerstandsnetzwerke, RC-Netzwerke und Verdrahtungen für Halbleiter-Chips, Flüssigkristallanzeigen, Plasma-Displays usw. Aufgabe der Erfindung ist es, ein Verfahren zur Herstellung von Dünnfilmschaltungen mit edelmetallfreiem Leiterbahnschichtaufbau zu entwickeln, das folgende Anforderungen zu erfüllen hat: Lötbarkeit, Temperfähigkeit (> 300 °C), Korrosionsbeständigkeit, niedriger Widerstand und Bondbarkeit. Diese Aufgabe wird erfindungsgemäß dadurch gelöst, daß auf eine im Vakuum aufgebrachte Kupferschicht (5) zusätzlich eine Oxidations- und Korrosionsschutzschicht aus Aluminium bzw. einer Aluminiumlegierung (6) oder einer Schichtkombination aus Chrom und Aluminium aufgebracht wird.

SIEMENS AKTIENGESELLSCHAFT
Berlin und München

Unser Zeichen
VPA 81 P 7014 E

Verfahren zur Herstellung von lötbaren und temperfähigen edelmetallfreien Dünnschichtleiterbahnen.

Die Erfindung betrifft ein Verfahren zur Herstellung von lötbaren und temperfähigen edelmetallfreien Dünnschichtleiterbahnen, die zusammen mit Bauelementen auf einem als Träger dienenden, elektrisch nicht leitendem Substrat in der Form einer integrierten Schicht- bzw. Hybridschaltung aufgebracht sind, wobei sich zwischen der aus Kupfer bestehenden Leiterbahnschicht und dem Substrat eine Haftschicht befindet.

Für alle Dünnfilmschaltungen ist zunächst ein isolierender Substratträger, z. B. Keramik, Glas, glasierte Keramik, Kunststoff und dergleichen, erforderlich, der eine geringe Oberflächenrauhigkeit besitzt. Auf diesem Substrat werden aus übereinanderliegenden Schichten aus leitendem Material, Widerstandsmaterial und/oder nichtleitendem Material Widerstände, Kondensatoren, Spulen und Leiterbahnen nach verschiedenen Verfahren hergestellt.

Aus Kupfer bestehende Leiterbahnen bzw. Kontaktstellen sind im ungetemperten Zustand gut lötbar und haben einen besseren Leitwert als solche aus Edelmetallkombinationen (z. B. CuNiAu, PdAu). Die Haftfestigkeit der Kupferschicht auf einem Substrat, z. B. aus Keramik, ist sehr schlecht. Diesen Nachteil sucht man dadurch zu beheben, daß man zuerst eine dünne Schicht auf das Substrat aufträgt, welche eine gute Haftfestigkeit auf dem Substratträger besitzt. Auf diese Haftschicht wird nun Kupfer als Leiterbahnmetall aufgetragen.

Edelmetallfreie Leiterbahnsysteme mit niedrigem Wider-

Wed 1 Plr/27.2.1981

stand, die lötbar und temperaturbeständig ( > 300°C) sind, werden nach bislang bekannten Verfahren entweder mit dicken, galvanisch verstärkten Schichten (z. B. Kupfer) hergestellt oder die Temperung erfolgt im Vakuumofen oder in Schutzgasatmosphäre. Die dünnen leitenden Schichten werden auf einem isolierenden Substrat durch Aufdampfen oder Aufstäuben im Vakuum aufgebracht und je nach Anwendung durch elektrochemisches Abscheiden verstärkt bzw. veredelt. Die Strukturerzeugung erfolgt entweder durch Bedampfen bzw. Aufstäuben durch mechanische Masken oder durch Foto- und Ätzprozesse.

Leiterbahnen aus Kupfer sind im ungetemperten Zustand gut lötbar. Bei höheren Temperaturen (ab 250°C), wie sie z. B. bei der Stabilisierung von Widerstandsschichten auftreten, erfolgt jedoch eine starke Oxidation der Kupferschicht. Die entstehende Kupferoxidschicht verhindert nicht die Fortsetzung des Oxidationsprozesses. Deshalb oxidieren bei diesen Temperaturprozessen relativ dicke Kupferleiterbahnen (z. B. 1 bis 3 $\mu$m) mit der Zeit durch und sind nicht mehr lötbar.

Der Erfindung liegt die Aufgabe zugrunde, ein Verfahren zur Herstellung von Dünnfilmschaltungen mit edelmetallfreiem Leiterbahnschichtaufbau zu entwickeln, das folgende Anforderungen zu erfüllen hat: Lötbarkeit, Temperfähigkeit ( > 300°C), Korrosionsbeständigkeit, niedriger Widerstand und Bondbarkeit. Diese Aufgabe wird für ein eingangs definiertes Verfahren dadurch gelöst, daß im Vakuum auf der als Zwischenschicht dienenden Haft- bzw. Widerstandsschicht (z. B. Titan, Chrom, Molybdän, Wolfram, Titanwolfram, Aluminium, Nickel, Nickelchrom, Tantalnitrid, Tantalaluminium, Zinnindiumoxid und dergleichen) und der Leitschicht aus Kupfer oder einer Kupfer/Nickellegierung zusätzlich eine Oxidations- und Korrosionsschutzschicht aus Aluminium bzw. einer Aluminiumlegierung (z. B. Aluminiumsilizium) aufgebracht wird. Bereits aufgedampfte bzw. aufgestäubte oder galvanisch verstärkte Kupferschichten können nachträglich im Vakuum mit Oxidationsschutzschichten entsprechend der Erfindung belegt werden.

Das Verfahren nach der Erfindung hat den Vorteil, daß durch Verzicht auf Edelmetalle die Herstellung von Dünnfilmschaltungen besonders kostengünstig wird. Das Gebiet der Dünnfilmtechnik umfaßt integrierte Hybridschaltungen, Widerstandsnetzwerke, RC-Netzwerke und Verdrahtungen für Halbleiterchips, Flüssigkristallanzeigen, Plasmadisplays usw.

Das erfindungsgemäße Verfahren ist insbesondere in Verbindung mit der Herstellung von Schichtschaltungen, bei denen Temperaturprozesse ($>300^{o}$C) durchgeführt werden und bei Schaltungen, die bei höheren Temperaturen betrieben werden, von Bedeutung.

Vorteilhafte Ausgestaltungen dieses Verfahrens sowie Merkmale bezüglich der Verwendung von Basismaterial in einer solchen Verfahrensweise ergeben sich aus den Unteransprüchen.

Die Erfindung wird anhand der Figuren, die vier verschiedene Varianten eines Schichtaufbaus im Schnitt zeigen, erläutert.

Figur 1 zeigt einen Schichtaufbau mit einer Widerstandsschicht (2), einer Haftschicht (3) und einer Leitschicht aus Kupfer (5) und einer Oxidations- und Korrosionsschutzschicht aus Aluminium (6).

Figur 2 diesen Schichtaufbau, wobei die Widerstandsschicht (2) zugleich eine Haftschicht ist.

Figur 3 zeigt einen Schichtaufbau mit einer Oxidations-und Korrosionsschutzschicht aus einer Schichtkombination aus Chrom (7) und Aluminium (6).

Figur 4 zeigt einen Schichtaufbau mit einer Zwischenschicht aus Aluminium (4) zwischen der Haftschicht und der Leitschicht.

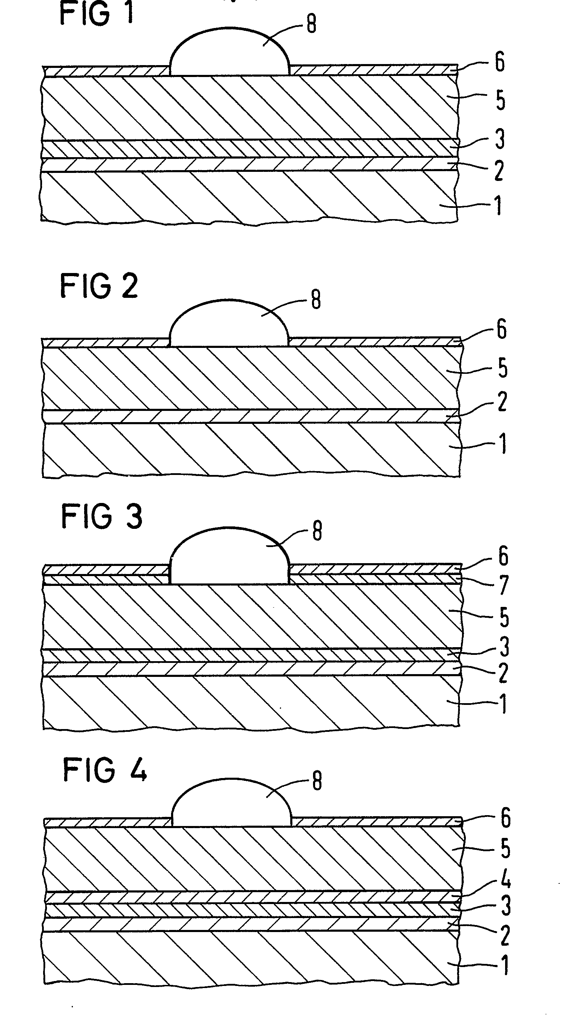

Der prinzipielle Schichtaufbau besteht aus einem Substrat 1, auf dem eine Widerstands- bzw. Widerstands-kondensatorschicht oder $In_2O_3/SnO_2$-(ITO-)Schicht 2 auf-gebracht ist. Darauf befindet sich eine Haftschicht 3, die z. B. aus Titan, Chrom, Aluminium und dergleichen bestehen kann. Die Haftschicht kann wie in Figur 2 dargestellt auch aus einer Widerstandsschicht bestehen. Nach der in der Figur 4 dargestellten Variante befindet sich auf der Haftschicht eine Zwischenschicht 4 aus Aluminium. Mit 5 ist die Leitschicht aus Kupfer oder einer Kupfer/Nickellegierung bezeichnet. Als Schutzschicht dient eine Oxidations- und Korrosionsschutzschicht 6 aus Aluminium bzw. Aluminiumlegierung oder einer Schichtkombination aus Chrom 7 und Aluminium 6.

Während der Temperung entsteht über die Korngrenzendiffusion eine Mischung aus Kupfer und Aluminium. Der Oxidationsschutz der Kupferschicht wird während des Temperprozesses ($\geqslant 300^{\circ}$C) durch die entstehende Alu-miniumoxid- und Aluminiumkupferlegierungsschicht ge-währleistet.

Nach den Temperaturprozessen wird durch verschiedene Ätzverfahren (Naßchemisches Ätzen, Ionenstrahlätzen, Sputterätzen) die Oxidationsschutzschicht an den Löt-stellen 8 entfernt. Die Benetzung der Lötstellen mit Lötzinn ist nach der Temperung ausgezeichnet. Die Verzahnung der Haft- und Leitschicht während der Temperung ist für das Lötverhalten vorteilhaft.

0060436

Der Schichtaufbau kann z. B. mit folgenden Schicht-stärken realisiert werden:

| | | | | |
|---|---|---|---|---|
| (2) Widerstandsschicht | 5 | - | 200 | nm |
| (3) Haftschicht | 10 | - | 500 | nm |
| (4) Zwischenschicht | 10 | - | 500 | nm |
| (5) Leitschicht | 300 | - | 5000 | nm |
| (6) Schutzschicht | 10 | - | 500 | nm |
| (7) Schutzschicht | 10 | - | 100 | nm |

Der Leiterbahnwiderstand des Gesamtschichtaufbaus z. B. bei Variante 4 (Figur 4) mit Titan 50 nm, Aluminium 20 nm, Kupfer 1500 nm und Aluminium 20 nm ist mit 0,012 $\Omega/\square$ relativ niedrig. Nach einer Temperung bei 400°C/0,5h in Luft erhöht sich der Widerstand nur auf 0,014 $\Omega/\square$ .

Bondversuche auf getemperten Schaltungen mittels Ultraschall zeigen, daß sowohl die Schutzschichten als auch die von der Schutzschicht freigelegten Kupferschichten mit Aluminiumdrähtchen bondbar sind.

8 Patentansprüche
4 Figuren

Patentansprüche.

1. Verfahren zur Herstellung von lötbaren und temperfähigen edelmetallfreien Dünnschichtleiterbahnen, die zusammen mit Bauelementen auf einem als Träger dienenden, elektrisch nicht leitendem Substrat in der Form einer integrierten Schicht- bzw. Hybridschaltung aufgebracht sind, wobei sich zwischen der aus Kupfer bestehenden Leiterbahnschicht und dem Substrat eine Haftschicht befindet, d a d u r c h   g e k e n n z e i c h n e t , daß im Vakuum auf der als Zwischenschicht dienenden Haft- bzw. Widerstandsschicht (z. B. Titan, Chrom, Molybdän, Wolfram, Titanwolfram, Aluminium, Nickel, Nickelchrom, Tantalnitrid, Tantalaluminium, Zinnindiumoxid und dergleichen) (2, 3) und der Leitschicht aus Kupfer oder einer Kupfer/Nickellegierung (5) zusätzlich eine Oxidations- oder Korrosionsschutzschicht aus Aluminium bzw. einer Aluminiumlegierung (z. B. Aluminiumsilizium) (6) aufgebracht wird.

2. Verfahren nach Anspruch 1, d a d u r c h   g e - k e n n z e i c h n e t ,   daß die als Haftschicht (3) dienende Zwischenschicht zugleich eine Widerstandsschicht (2) ist, die z. B. aus Nickel-Chrom, Tantalnitrid, Tantal-Aluminium, Zinn-Indium-Oxid (2) oder anderen Widerstandsschichten besteht.

3. Verfahren nach Anspruch 1 und 2, d a d u r c h   g e k e n n z e i c h n e t ,   daß die Leitschicht aus einer Kupfer/Nickellegierung (5) besteht.

4. Verfahren nach Anspruch 1 bis 3, d a d u r c h   g e k e n n z e i c h n e t ,   daß die Oxidations- und Korrosionsschutzschicht aus einer Schichtkombination aus Chrom (7) und Aluminium (6) besteht.

5. Verfahren nach Anspruch 1 bis 4, d a d u r c h

g e k e n n z e i c h n e t , daß zur Verbesserung des Korrosionsschutzes eine Aluminiumschicht (4) zwischen der Haftschicht (3) bzw. Widerstandsschicht (2) und der Kupferleiterbahnschicht (5) aufgebracht wird.

6. Verfahren nach Anspruch 1 bis 5, d a d u r c h g e k e n n z e i c h n e t , daß der Schichtaufbau, bestehend aus Haft- (3) bzw. Widerstandsschicht (2), Leitschicht (5) und Schutzschicht (6, 7), durch Aufdampfen bzw. Aufstäuben in einem Vakuumprozeß hergestellt wird.

7. Verfahren nach Anspruch 1 bis 5, d a d u r c h g e k e n n z e i c h n e t , daß die Schutzschicht (6,7) aus Aluminium bzw. einer Aluminiumlegierung in einem separaten Vakuumprozeß auf der Kupferschicht aufgebracht wird.

8. Verfahren nach Anspruch 1 bis 7, d a d u r c h g e k e n n z e i c h n e t , daß nach den Temperaturprozessen die Oxidations- und Korrosionsschutzschicht (6), bestehend aus Aluminiumoxid und Aluminiumkupferlegierung durch Ätzverfahren an den Lötstellen (8) entfernt wird.

1/1

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| A | DE-A-2 522 944 (SIEMENS) <br> * Anspruch 1 * <br><br> --- | 1 | H 01 L 27/01 |
| A | GB-A-1 527 108 (WESTERN ELECTRIC COMP.) <br><br> --- | | |
| A | DE-A-2 108 730 (MOTOROLA) <br><br> --- | | |
| A | IEEE TRANSACTIONS ON COMPONENTS, HYBRIDS, AND MANUFACTURING TECHNOLOGY, Band CHMT-2, Nr. 2, Juni 1979, Seiten 218-221, New York, USA <br> D.V. KERNS et al.: "A low-cost thin-film microcircuit process" <br><br> ----- | | |

**RECHERCHIERTE SACHGEBIETE (Int. Cl. ³)**

H 01 L 27/01

Der vorliegende Recherchenbericht wurde für alle Patentansprüche erstellt.

| Recherchenort | Abschlußdatum der Recherche | Prüfer |
|---|---|---|
| DEN HAAG | 25-06-1982 | PELSERS L. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument

EPA Form 1503. 03.82